# EUROPEAN PATENT SPECIFICATION

(11) **EP 2 284 289 B1**
(45) Date of publication and mention of the grant of the patent: **22.01.2014**
(21) Application number: 09758167.2
(22) Date of filing: 16.04.2009
(51) Int. Cl.: C22C 27/04, B22F 3/105, C23C 14/16, C23C 14/34, C22C 1/04

(54) **TUNGSTEN SINTERED MATERIAL SPUTTERING TARGET**
SPUTTERING-TARGET AUS TUNGSTENGESINTERTEM MATERIAL
CIBLE DE PULVÉRISATION DE MATÉRIAU FRITTÉ DE TUNGSTÈNE

(30) Priority: 02.06.2008 JP 2008144520
(43) Date of publication of application: 16.02.2011
(73) Proprietor: JX Nippon Mining & Metals Corporation, Tokyo 100-8164 (JP)
(72) Inventor: SUZUKI, Ryo, Kitaibaraki-shi Ibaraki 319-1535 (JP); ODA, Kunihiro, Kitaibaraki-shi Ibaraki 319-1535 (JP)
(74) Representative: Hoarton, Lloyd Douglas Charles
(86) International application number: PCT/JP2009/057639
(87) International publication number: WO 2009/147900

(56) References cited:
- JP-A- 1 172 226
- JP-A- 1 172 226
- JP-A- 1 198 471
- JP-A- 2 311 394
- JP-A- 6 158 300
- JP-A- 7 076 771
- JP-A- 7 076 771
- JP-A- 8 250 427
- JP-A- 2000 256 836
- JP-A- 2003 055 758
- JP-A- 2003 171 760
- JP-A- 2005 307 235
- JP-B2- 3 086 447

## Description

### TECHNICAL FIELD

The present invention relates to a tungsten sintered target to be used when forming a gate electrode, a wiring material or others for an IC, LSI or the like through the sputtering method.

### BACKGROUND ART

In recent years, pursuant to the higher integration of very-large-scale integrated circuits (VLSI), studies are being conducted for using materials having lower electrical resistivity as the electrode material or the wiring material. Under the foregoing circumstances, high-purity tungsten having low resistivity and thermal and chemical stability is being used as the electrode material or the wiring material.

The foregoing electrode material or wiring material for VLSI is generally produced by way of the sputtering method or the CVD method, but the sputtering method is being widely used in comparison to the CVD method since the structure and operation of the sputtering device are relatively simple, deposition can be performed easily, and the process is of low cost.
Nevertheless, a tungsten target that is used for the deposition of the electrode material or wiring material for VLSI in the sputtering method is required of a relatively large size of 300mmφ or larger, and is further demanded of high purity and high density.

Conventionally, as methods of preparing this kind of large-size tungsten target, the following methods are known; namely, a method of preparing an ingot by way of electron beam melting and subjecting the obtained ingot to hot rolling (Patent Document 1), a method of subjecting tungsten powder to pressure sintering and thereafter to rolling (Patent Document 2), and a so-called CVD-W method of laminating a tungsten layer on the entire surface of a tungsten bottom plate by way of the CVD method (Patent Document 3).

Nevertheless, with the method of rolling the ingot obtained based on electron beam melting or the sintered compact obtained by subjecting tungsten powder to pressure sintering, there are problems in that the target is mechanically fragile since the crystal grains easily coarsen, and granular defects referred to as particles are easily generated on the sputtered film. Moreover, although the CVD-W method yields favorable sputtering characteristics, there is a problem in that it is extremely time-consuming and expensive to prepare the target.

In addition, disclosed is technology of using tungsten powder containing 2 to 20ppm of phosphorus (P) as the raw material, and sintering this raw material by way of hot pressing and HIP in order to produce a tungsten target having an average grain size of φ40µm or less (refer to Patent Document 4).

In the foregoing case, the requirement is the inclusion of phosphorus in an amount of 2ppm or more, and the inclusion of phosphorus caused a problem of deteriorating the grain boundary intensity of the sintered compact. In particular, if large amounts of phosphorus are contained, the abnormal grain growth of tungsten occurs easily, and grains of approximately 500µm will be scattered about. Phosphorus will be concentrated at grain boundary of the crystal subject to the foregoing abnormal grain growth and further deteriorate the grain boundary intensity, and there is a problem in that chipping will occur during the machining process for grinding the target and the product yield will deteriorate.

Although it is possible to devise the sintering conditions as a measure for preventing the abnormal grain growth of tungsten or in order to resolve the problem of the concentration of phosphorus, there is a problem in that this merely results in a more complex production process and does not offer a solution for stable production.

In addition, disclosed is technology of acquiring a high-purity tungsten target having a purity level of 3N5 to 7N and an average grain size of 30µm (refer to Patent Document 5). Nevertheless, in the foregoing case, the total impurity content and the impurities which are undesirable in semiconductors (Fe, Cr, Ni, Na, K, U, Th, etc.) are merely prescribed, and there is no disclosure regarding the problems caused by the inclusion of phosphorus.

Accordingly, this technology has numerous problems; specifically, occurrence of defective targets, deterioration of yield in the target production process, increase in production costs and so on.
[Patent Document 1] Japanese Laid-Open Patent Publication No. S61-107728
[Patent Document 2] Japanese Laid-Open Patent Publication No. H3-150356
[Patent Document 3] Japanese Laid-Open Patent Publication No. H6-158300
[Patent Document 4] Japanese Laid-Open Patent Publication No. 2005-307235
[Patent Document 5] International Publication No. WO2005/73418
JP 7 076771 A discloses a tungsten sputtering target having ≥ 99.5% relative density and an average grain size between 10 and 200 µm.
JP 2000 256836 A discloses a tungsten sputtering target having 0.1 to 10 ppm oxygen content, ≥ 99% relative density and ≤ 80 µm crystal grain size.
JP 6 158300 A discloses forming a tungsten target material by the CVD method.
JP 8 250427 A discloses a tungsten sputtering target based on the CVD reaction of tungsten hexafluoride and hydrogen.
JP 2 311394 A discloses a monocrystal tungsten sputtering target produced by an electron beam melting method.
JP 2003 055758 A discloses a method for producing a tungsten sputtering target with ≥ 99% relative density, ≤ 100µm average particle size and with ≤ 20 ppm oxygen content.

### DISCLOSURE OF INVENTION

In light of the above, it has been discovered that the inclusion of phosphorus heavily affects the abnormal grain growth of tungsten and the deterioration in the target strength. In particular, if phosphorus is contained in an amount exceeding 1 ppm, crystal grains subject to abnormal grain growth will exist in the tungsten target, and grains of approximately 500µm will be scattered about. Moreover, it has also been discovered that phosphorus will be concentrated at grain boundary of the crystal subject to the foregoing abnormal grain growth and deteriorate the grain boundary intensity. Thus, an object of this invention is to prevent the abnormal grain growth of tungsten and improve the production yield of the target by strongly recognizing the phosphorus contained in the tungsten as a harmful impurity and controlling the inclusion thereof to be as low as possible.

In order to achieve the foregoing object, the present inventors provide the following invention:
1) A tungsten sintered sputtering target, according to claim 1, wherein the total impurity concentration comprising phosphorus is 10wtppm or less, wherein the phosphorus content is between 0.01 and 1wtppm or less and the remainder is other unavoidable impurities and tungsten;

2) The tungsten sintered sputtering target according to the above 1), wherein the phosphorus content is 0.5wtppm or less;

The tungsten sintered sputtering target of the invention has a relative density of 99% or higher and an average crystal grain size of 50µm or less; and wherein the oxygen content and carbon content as gas components are respectively 50wtppm or less.

Preferred embodiments are disclosed on claims 3-5.

As a result of reducing the foregoing phosphorus content to be 1wtppm or less, the abnormal grain growth of tungsten can be effectively inhibited. It is thereby possible to prevent the deterioration in the target strength and resolve, at once, such numerous problems with a tungsten sintered target as occurrence of defective targets, deterioration of yield in the target production process, and increase in production costs. The present invention additionally yields a superior effect of being able to improve the uniformity of the tungsten wiring film.

### BEST MODE FOR CARRYING OUT THE INVENTION

The sintered target for sputtering according to the present invention reduces the phosphorus content to be between 0.01 and 1wtppm. Although the remainder is tungsten and oxygen and carbon gas components as defined in claim 1, the unavoidable impurities other than phosphorus exist and are included therein. Phosphorus is also an impurity, and in particular heavily affects the generation of coarse grains in the tungsten sintered target among the other impurities. Therefore, phosphorus must be strictly controlled. The phosphorus content is desirably 0.5wtppm or less. This can be achieved by reducing the phosphorus contained in the sintering raw powder.

The abundance of phosphorus must be reduced as much as possible as described above, and the lower limit of such abundance is 0.01wtppm, which is the standard minimum detection limit. If it is possible to reduce the abundance to this level, the foregoing problems of the sintered target for sputtering according to the present invention will be nonexistent.

High-purity tungsten powder from which phosphorus is reduced as much as possible can be obtained using a heretofore known method (refer to Japanese Laid-Open Patent Publication No. H1-172226; a method developed by the present Applicant). For example, ammonium metatungstate is dissolved in water to create a tungsten-containing aqueous solution; inorganic acid is added to the tungsten-containing aqueous solution; the solution is heated to precipitate tungstate crystals; after performing solid-liquid separation, the tungstate crystals are dissolved in ammonia water to create a purified mother liquor for ammonium paratungstate crystal precipitation and an undissolved residue containing impurities such as iron; the undissolved residue is subject to separation cleaning; the purified mother liquor for ammonium paratungstate crystal precipitation is heated; and inorganic acid is added to adjust the PH for precipitating the ammonium paratungstate crystals; whereby high-purity ammonium paratungstate crystals are produced.

The ammonium paratungstate crystals obtained with the foregoing method are dried and calcined to obtain anhydrous tungstate, and hydrogen reduction is additionally performed at high temperature in order to obtain high-purity tungsten powder. In the foregoing case, it is important that the phosphorous content in the tungsten powder is 1wtppm or less.

Subsequently, the tungsten powder having a phosphorus content of 1wtppm or less may be sintered according to a heretofore known method. For example, a heretofore known method, in which pressure sintering is performed in vacuum after plasma treatment of applying high-frequency current to the tungsten powder under vacuum and generating plasma between the tungsten powder surfaces, or pressure sintering is performed simultaneously with plasma treatment of applying high-frequency current to the tungsten powder under vacuum and generating plasma between the tungsten powder surfaces, can be used (refer to Japanese Patent No. 3086447). Incidentally, this publically known art is a method that was developed by the present Applicant.

Normally, finer the grain size of the powder to be used in powder metallurgy, more favorable the sinterability. Nevertheless, since tungsten is an easily-oxidizable material, if the powder grain size is fine, an oxide layer is formed on the surface and the sinterability will deteriorate. Since the foregoing technology enables to eliminate the oxide layer on the tungsten powder surface by performing plasma treatment to the tungsten powder before or simultaneously with performing pressure sintering, it is possible to use fine tungsten powder and improve the sinterability.

If there is an oxide layer on the surface of the tungsten raw powder, it is difficult to improve the density since the WO₃ evaporates during the sintering process and remain as pores. Meanwhile, under this technology, since the oxide layer is eliminated by way of plasma treatment at the stage before the sintering progresses, it is possible to reduce the residual pores resulting from evaporation of WO₃ and achieve high density. In addition, with the method of performing hot pressing while performing plasma treatment, since it has an effect of eliminating the oxide layer of the powder surface and the neck growth is promoted with the generation of plasma, sintering will advance at a lower temperature. This method yields the effect of reducing oxygen.

This method enables to obtain a tungsten target for sputtering, wherein an oxygen content and a carbon content are respectively 50wtppm or less, even the oxygen content is 0.1 to 10ppm, the relative density is 99% or higher, and the crystal grain size is 50µm or less. This sintering method for a target is able to prevent problems such as an abnormal electrical discharge occurring during the sputtering process, or numerous defect particles being generated on the sputtered film. In addition, sufficient target strength can be obtained and the problem of the target cracking during the operation or use thereof can be prevented. Accordingly, this known sintering method is effective for the present invention.

With the tungsten sintered sputtering target of the present invention, the relative density is 99% or higher and the average crystal grain size is 50µm or less. This can be achieved based on the sintering conditions shown below, and it is considered that the effect from the reduction of phosphorus is influencing the foregoing result.

Improvement in the density is favorable since this will increase the target strength. Moreover, since the refinement of the crystal grain size will also increase the strength, the average crystal grain size is made to be 50µm or less. Since the refinement of the crystal grain size will also lead to dispersion of the impurities that get inevitably mixed in into the grain boundary, there is an advantage in that a uniform structure can be easily obtained.

Although it is apparent when closely observing a sintered tungsten target, abnormal grains having a grain size exceeding 50µm are generated in the vicinity of the target surface, particularly in a region of layer within 1 to 10mm from the surface. In particular, if the phosphorus content exceeds 1.0wtppm, there is an abnormal growth region where the grain size exceeds 500µm, in the vicinity of the target surface. The region where abnormally grown grains are generated will remain in the vicinity of the surface if the phosphorus content is 1.0wtppm or less, but will gradually spread to the inside of the tungsten target if such phosphorus content increases in excess of 1.0wtppm. Moreover, the frequency of abnormally grown grains will also increase.

Generally speaking, if the foregoing abnormally grown coarse grains exist, they can be eliminated by grinding the surface. However, if the abnormal growth region has spread internally, it is undeniable that the amount of grinding to be performed for eliminating the coarse grains will increase. This means that the product yield will significantly decrease. Moreover, the yield will decrease even further since the existence of coarse grains will cause chipping during the machining process, and it will cause the production cost to increase.

Thus, although there is a method to limit the machining process and obtain a tungsten target in which the existence of abnormal grains having a grain size exceeding 50µm are overlooked, the existence of coarse grains causes the sputtering rate to become uneven and also causes a new problem of deteriorating the uniformity of the deposited film.

Accordingly, it could be said that, preferably, the generation area of abnormal grains is kept in a region of layer within 1mm from the surface. If the amount of phosphorus is reduced, the generation of abnormal grains having a grain size exceeding 50µm will decrease enormously.

In the tungsten sintered sputtering target of the present invention, it is preferred that the total impurity concentration is 10wtppm or less, and the oxygen content and carbon content as gas components are respectively 50wtppm or less.

In particular, since the gas components of oxygen and carbon are combined with the impurities contained in the tungsten to form oxides and carbides, it is preferable to reduce the gas components as much as possible. In addition, the gas components of oxygen and carbon also react with tungsten to similarly form oxides and carbides. Since these get mixed into the inside of the wiring material for LSI during the sputtering deposition process and will cause the function of the tungsten wiring to deteriorate, these should be reduced as much as possible.

As described above, the tungsten sintered sputtering target of the present invention is able to effectively inhibit the abnormal grain growth of crystals, and it is thereby possible to prevent the deterioration in the target strength and resolve the numerous problems with a tungsten sintered target; specifically, occurrence of defective targets, deterioration of yield in the target production process, increase in production costs and so on. The present invention additionally yields a superior effect of being able to improve the uniformity of the tungsten wiring film as a result of sputtering with this target.

In addition, improvement in the density of the sputtering target of the present invention leads to reduction of pores, refinement of crystal grains, and uniformity and smoothing of the sputtered surface of the target. Thus, the present invention yields the effect of being able to reduce the generation of particles and nodules during the sputtering process and additionally extend the target life, and also yields the effect of being able to reduce the variation in quality and improve mass productivity.

### [Examples]

The Examples and Comparative Examples of the present invention are now explained. These Examples are merely illustrative, and the present invention shall in no way be limited thereby. In other words, various modifications and other embodiments based on the technical spirit claimed in the claims shall be included in the present invention as a matter of course.

### (Example 1)

After tungsten powder having a purity of 99.999%, a phosphorus content of less than 0.1wtppm and an average grain size of 0.6µm was filled in a graphite die and it was sealed with an upper punch and a lower punch of the same material, the die was depressurized to a vacuum of 10⁻²Pa. Subsequently, a high-frequency current of approximately 4000A was applied to the upper and lower punches for 10 minutes to generate plasma between the surfaces of tungsten powder in the die, and the powder surfaces were thereby cleaned and activated. Then, after stopping the application of the high-frequency current, pressure of 30MPa was applied to the die, and the die was externally heated to 1800°C and subsequently maintained at that temperature for 2 hours.

The relative density of the obtained tungsten sintered compact was 99.9% and the average crystal grain size was 30µm. The existence of an abnormal grain size could not be acknowledged. In addition, the oxygen content was 3ppm.

As a result of sputtering with this tungsten sintered compact as the target, the number of particles on the film was 0.09 particles/cm². It is considered that the number of particles reduced considerably since there were no abnormal grains. The results are shown in Table 1.

**[Table 1]**

| | Phosphorus content | Abnormal grain size | Frequency of abnormal grains | Depth from surface | Number of particles |
|---|---|---|---|---|---|
| | (ppm) | (µm) | (grains/cm²) | (mm) | (particles/cm²) |
| Example 1 | <0.1 | - | - | - | 0.09 |
| Example 2 | 0.5 | - | - | - | 0.07 |
| Example 3 | 0.8 | 70 | 0.0006 | 0.5 | 0.4 |
| Example 4 | 1.0 | 150 | 0.003 | 0.8 | 0.9 |
| Comparative Example 1 | 1.2 | 600 | 0.05 | 2 | 10 |
| Comparative Example 2 | 1.7 | 900 | 0.2 | 10 | 30 |

### (Example 2)

After tungsten powder having a purity of 99.999%, a phosphorus content of 0.5wtppm and an average grain size of 0.6µm was filled in a graphite die and it was sealed with an upper punch and a lower punch of the same material, the die was depressurized to a vacuum of 10⁻²Pa.

Pressure of 30MPa was applied while applying a high-frequency current, as with Example 1, to generate plasma between the tungsten powder surfaces, and the powder surfaces were thereby cleaned and activated while simultaneously performing pressure sintering.

During the sintering process, the temperature was elevated up to 1550°C based on the self-heating resulting from the current applied to the die and the filled tungsten powder, and the die was maintained at that temperature for 2 hours.

The relative density of the obtained tungsten sintered compact was 99.8% and the average crystal grain size was 38µm. The existence of an abnormal grain size could not be acknowledged. The oxygen content was 9ppm. Since the process was performed under conditions of a low sintering temperature, the crystal growth was small and the density was not that high, but these were within a satisfactory range. In addition, even though the grain size of the powder was small, the oxygen content was low. The number of particles on the film that was deposited by using the foregoing tungsten sintered compact as the target was 0.07 particles/cm², and showed a favorable result. It is considered that the number of particles reduced considerably since there were no abnormal grains. The results are similarly shown in Table 1.

### (Example 3)

After tungsten powder having a purity of 99.999%, a phosphorus content of 0.8wtppm and an average grain size of 0.6µm was filled in a graphite die and it was sealed with an upper punch and a lower punch of the same material, the die was depressurized to a vacuum of 10⁻²Pa.

Pressure of 30MPa was applied while applying a high-frequency current, as with Example 1, to generate plasma between the tungsten powder surfaces, and the powder surfaces were thereby cleaned and activated while simultaneously performing pressure sintering.

During the sintering process, the temperature was elevated up to 1550°C based on the self-heating resulting from the current applied to the die and the filled tungsten powder, and the die was maintained at that temperature for 2 hours.

The relative density of the obtained tungsten sintered compact was 99.5% and the average crystal grain size was 45µm. The existence of an abnormal grain size was acknowledged, and the diameter thereof was 70µm. The region where these grains of abnormal size exist was a shallow region of layer within 0.5mm from the surface, and the frequency of abnormal grains was low at 0.0006 grains/cm² and did not cause any particular problem. Moreover, the grains existed in a region of being easily eliminated by mechanical grinding. An abnormal grain size did not exist anywhere deeper than 0.5mm from the surface.

Moreover, the oxygen content was 9ppm. Since the process was performed under conditions of a low sintering temperature, the crystal growth was small and the density was not that high, but these were within a satisfactory range. In addition, even though the grain size of the powder was small, the oxygen content was low.

The number of particles on the film that was deposited by using the foregoing tungsten sintered compact as the target was 0.4 particles/cm², and showed a favorable result. The results are similarly shown in Table 1.

### (Example 4)

After tungsten powder having a purity of 99.999%, a phosphorus content of 1.0wtppm and an average grain size of 0.6µm was filled in a graphite die and it was sealed with an upper punch and a lower punch of the same material, the die was depressurized to a vacuum of 10⁻²Pa.

Pressure of 30MPa was applied while applying a high-frequency current, as with Example 1, to generate plasma between the tungsten powder surfaces, and the powder surfaces were thereby cleaned and activated while simultaneously performing pressure sintering.

During the sintering process, the temperature was elevated up to 1550°C based on the self-heating resulting from the current applied to the die and the filled tungsten powder, and the die was maintained at that temperature for 2 hours.

The relative density of the obtained tungsten sintered compact was 99.1% and the average crystal grain size was 45µm. The existence of an abnormal grain size was acknowledged, and the diameter thereof was 150µm. The region where these grains of abnormal size exist was a relatively shallow region of layer within 0.8mm from the surface, and the frequency of abnormal grains was also low at 0.003 grains/cm² and did not cause any particular problem. Moreover, the grains existed in a region of being easily eliminated by mechanical grinding. An abnormal grain size did not exist anywhere deeper than 0.8mm from the surface.

Moreover, the oxygen content was 9ppm. Since the process was performed under conditions of a low sintering temperature, the crystal growth was small and the density was not that high, but these were within a satisfactory range. In addition, even though the grain size of the powder was small, the oxygen content was low.

The number of particles on the film that was deposited by using the foregoing tungsten sintered compact as the target was 0.9 particles/cm², and showed a favorable result. The results are similarly shown in Table 1.

### (Comparative Example 1)

After tungsten powder having a purity of 99.999%, a phosphorus content of 1.2wtppm and an average grain size of 0.6µm was filled in a graphite die and it was sealed with an upper punch and a lower punch of the same material, the die was depressurized to a vacuum of 10⁻²Pa.

Pressure of 30MPa was applied while applying a high-frequency current, as with Example 1, to generate plasma between the tungsten powder surfaces, and the powder surfaces were thereby cleaned and activated while simultaneously performing pressure sintering.

During the sintering process, the temperature was elevated up to 1550°C based on the self-heating resulting from the current applied to the die and the filled tungsten powder, and the die was maintained at that temperature for 2 hours.

The relative density of the obtained tungsten sintered compact was 99.0% and the average crystal grain size was 100µm. The existence of an abnormal grain size was acknowledged, and the diameter thereof was 600µm. The region where these grains of abnormal size exist was within 2mm from the surface, and the frequency of abnormal grains was high at 0.05 grains/cm² and became a problem. Moreover, the grains could not be easily eliminated with mechanical grinding, and it was a troublesome task. It was confirmed that the existence of the abnormal grain size was caused by the inclusion of phosphorus. The oxygen content was 9ppm.

The number of particles on the film that was deposited by using the foregoing tungsten sintered compact as the target was 10 particles/cm², and numerous particles were generated. The results are similarly shown in Table 1.

### (Comparative Example 2)

After tungsten powder having a purity of 99.999%, a phosphorus content of 1.7wtppm and an average grain size of 0.6µm was filled in a graphite die and it was sealed with an upper punch and a lower punch of the same material, the die was depressurized to a vacuum of 10⁻²Pa.

Pressure of 30MPa was applied while applying a high-frequency current, as with Example 1, to generate plasma between the tungsten powder surfaces, and the powder surfaces were thereby cleaned and activated while simultaneously performing pressure sintering.

During the sintering process, the temperature was elevated up to 1550°C based on the self-heating resulting from the current applied to the die and the filled tungsten powder, and the die was maintained at that temperature for 2 hours.

The relative density of the obtained tungsten sintered compact was 99.0% and the average crystal grain size was 200µm. The existence of an abnormal grain size was acknowledged, and the diameter thereof was 900µm. The region where these grains of abnormal size exist was within 10mm from the surface, and the frequency of abnormal grains was high at 0.2 grains/cm² and became a major problem. Moreover, the grains could not be easily eliminated with mechanical grinding, and it was a troublesome task. It was confirmed that the existence of the abnormal grain size was caused by the inclusion of phosphorus. The oxygen content was 9ppm.

The number of particles on the film that was deposited by using the foregoing tungsten sintered compact as the target was 30 particles/cm², and numerous particles were generated. The results are similarly shown in Table 1.

### INDUSTRIAL APPLICABILITY

As a result of reducing the phosphorus content to be 1wtppm or less, the abnormal grain growth of tungsten can be effectively inhibited. It is thereby possible to prevent the deterioration in the target strength and resolve, at once, such numerous problems with a tungsten sintered target as occurrence of defective targets, deterioration of yield in the target production process, and increase in production costs. The present invention additionally yields a superior effect of being able to improve the uniformity of the tungsten wiring film. Accordingly, the tungsten sintered sputtering target of the present invention is effective for use in producing an LSI wiring film.

## Claims

1. A tungsten sintered sputtering target consisting of tungsten, an impurity concentration comprising phosphorus, and oxygen and carbon gas components, wherein:
the total impurity concentration is 10 wtppm or less, wherein the phosphorus content is between 0.01 and 1 wtppm;
the oxygen content and carbon content as gas components are respectively 50 wtppm or less;
the relative density of the sputtering target is 99% or higher; and
the average crystal grain size of the sputtering target is 50 µm or less.

2. The tungsten sintered sputtering target according to claim 1, wherein the phosphorus content is between 0.01 and 0.5 wtppm.

3. The tungsten sintered sputtering target of claim 1 or 2, wherein an abnormally grown grain having a grain size exceeding 500 µm does not exist anywhere deeper than 1 mm from the surface.

4. The tungsten sintered sputtering target of claim 1 or 2, wherein an abnormally grown grain having a grain size exceeding 150 µm does not exist anywhere deeper than 1 mm from the surface.

5. The tungsten sintered sputtering target of claim 1 or 2, wherein the abnormally grown grains are only generated within a range of 1 mm from the surface, and the grain size of the abnormally grown grains that are generated is 150µm or less.

## Patentansprüche

1. Wolframgesintertes Sputtertarget, das aus Wolfram, einer Verunreinigungskonzentration, die Phosphor umfasst, sowie Sauerstoff- und Kohlenstoffgaskomponenten besteht, wobei:
die gesamte Verunreinigungskonzentration höchstens 10 Gew.-ppm beträgt, wobei der Phosphorgehalt zwischen 0,01 und 1 Gew.-ppm liegt;
der Sauerstoffgehalt und Kohlenstoffgehalt als Gaskomponenten jeweils höchstens 50 Gew.-ppm betragen;
die relative Dichte des Sputtertargets mindestens 99% beträgt; und
die durchschnittliche Kristallkorngröße des Sputtertargets höchstens 50 µm beträgt.

2. Wolframgesintertes Sputtertarget nach Anspruch 1, wobei der Phosphorgehalt zwischen 0,01 und 0,5 Gew.-ppm liegt.

3. Wolframgesintertes Sputtertarget nach Anspruch 1 oder 2, wobei ein anomal gewachsenes Korn mit einer Korngröße, die 500 µm überschreitet, nirgendwo tiefer als 1 mm von der Oberfläche vorhanden ist.

4. Wolframgesintertes Sputtertarget nach Anspruch 1 oder 2, wobei ein anomal gewachsenes Korn mit einer Korngröße, die 150 µm überschreitet, nirgendwo tiefer als 1 mm von der Oberfläche vorhanden ist.

5. Wolframgesintertes Sputtertarget nach Anspruch 1 oder 2, wobei die anomal gewachsenen Körner nur innerhalb eines Bereichs von 1 mm von der Oberfläche erzeugt werden und die Korngröße der anomal gewachsenen Körner, die erzeugt werden, höchstens 150 µm beträgt.

## Revendications

1. Cible de pulvérisation frittée en tungstène comprenant du tungstène, une concentration d'impuretés consistant en du phosphore et des composants gazeux d'oxygène et de carbone, dans laquelle :
la concentration totale en impuretés est inférieure ou égale à 10 ppm, la teneur en phosphore étant comprise entre 0,01 et 1 ppm en poids ;
la teneur en oxygène et la teneur en carbone sous forme de composants gazeux sont respectivement inférieures ou égales à 50 ppm en poids ;
la densité relative de la cible de pulvérisation est supérieure ou égale à 99 % ; et
la taille moyenne des grains de cristal de la cible de pulvérisation est inférieure ou égale à 50 µm.

2. Cible de pulvérisation frittée en tungstène selon la revendication 1, dans laquelle la teneur en phosphore est comprise entre 0,01 et 0,5 ppm en poids.

3. Cible de pulvérisation frittée en tungstène selon la revendication 1 ou 2, dans laquelle il n'y a aucun grain ayant une taille anormalement élevée de granulométrie supérieure à 500 µm à une profondeur supérieure à 1 mm par rapport à la surface.

4. Cible de pulvérisation frittée en tungstène selon la revendication 1 ou 2, dans laquelle il n'y a aucun grain ayant une taille anormalement élevée de granulométrie supérieure à 150 µm à une profondeur supérieure à 1 mm par rapport à la surface.

5. Cible de pulvérisation frittée en tungstène selon la revendication 1 ou 2, dans laquelle les grains ayant une taille anormalement élevée sont produits uniquement dans un intervalle de 1 mm à partir de la surface, et la granulométrie des grains générés ayant une taille anormalement élevée est inférieure ou égale à 150 µm.
